# EUROPEAN PATENT SPECIFICATION

(11) **EP 1 820 870 B1**
(45) Date of publication and mention of the grant of the patent: **02.09.2009**
(21) Application number: 05803017.2
(22) Date of filing: 08.11.2005
(51) Int. Cl.: C22C 47/06, C22C 47/20

(54) **METAL-BASEd CARBON FIBER COMPOSITE MATERIAL AND PRODUCTION METHOD THEREOF**
METALLBASIS-KOHLENSTOFFFASER-VERBUNDMATERIAL UND HERSTELLUNGSVERFAHREN DAFÜR
MATÉRIAU COMPOSITE DE FIBRE DE CARBONE À BASE DE MÉTAL ET PROCÉDÉ DE FABRICATION IDOINE

(30) Priority: 09.11.2004 JP 2004325545
(43) Date of publication of application: 22.08.2007
(73) Proprietor: Shimane Prefectural Government, Matsue-shi, Shimane 690-8501 (JP)
(72) Inventor: ONO, Mikiya, c/o Shimane Institute for Industrial Technology, Matsue-shi, Shimane 690-816 (JP); UENO, Toshiyuki, c/o Shimane Institute for Industrial Technology, Matsue-shi, Shimane 690-816 (JP)
(74) Representative: Winter, Brandl, Fürniss, Hübner Röss, Kaiser, Polte Partnerschaft Patent- und Rechtsanwaltskanzlei
(86) International application number: PCT/JP2005/020452
(87) International publication number: WO 2006/051782

(56) References cited:
- EP-A- 0 540 214
- JP-A- 53 066 831
- JP-A- 57 164 947
- JP-A- 60 169 534
- JP-A- 60 200 929
- JP-A- 61 144 287
- JP-A- 63 109 128
- JP-A- 2002 194 515
- JP-A- 2002 294 359
- JP-A- 2002 363 716
- JP-A- 2005 200 676
- JP-A- 2005 272 945
- US-A- 3 606 667
- US-A- 3 984 043
- US-A- 4 110 505

## Description

### Technical Field

The present invention relates to a producing method of a metal-based carbon fiber composite material. In detail, the present invention relates to a metal-based carbon fiber composite material having high thermal conductivity suitable for heat dissipation of a device that operates in a temperature range from room temperature to several hundreds degree centigrade and a producing method thereof, and, in more detail, relates to a metal-based carbon fiber composite material having a structure where a metal layer and a metal layer containing carbon fibers are alternately stacked and a producing method thereof.

### Background Art

So far, aluminum, copper or an alloy thereof is mainly used as a heat dissipation member (such as a substrate, heat-sink, heat-spreader and the like) of an electronic device or a powder module that uses a semiconductor or a peripheral member of a heater of a mechanical unit, because of excellent workability and relatively high thermal conductivity. Furthermore, when more excellent thermal conductivity and/or insulating property are necessary, graphite or high thermal conductivity materials such as beryllia, silicon nitride, aluminum nitride, silicon carbide or the like are used. However, these materials are not so much used, because of their high cost. However, as the performances of the devices are improved, increasing tendency of heat generation in the devices is remarkable. Furthermore, as the miniaturization and weight saving of the devices are forwarded, the miniaturization and weight saving of the heat dissipation member are further demanded, and still furthermore, a high performance and cheap heat dissipation member is in demand.

With relation to the problems, graphite that is higher in the thermal conductivity than metals such as aluminum and copper or alloys is in use. However, there is a problem in that carbon powder generated and released from graphite disturbs neighboring electronic circuits. Furthermore, high thermal conductivity ceramics such as silicon nitride have been used for heat sinks for LSIs of hybrid car controllers or the like as well. However, more excellent thermal conductivity and large dropping in price are demanded from users and the ceramic material cannot cope with such demands.

In view of such a situation, more attention has been focused on a metal-based carbon fiber composite material using a carbon fiber that is excellent in the thermal conductivity and light in weight. Such a metal-based carbon fiber composite material is generally formed by means of a melt impregnation process wherein a melt of a metal such as aluminum is impregnated with or without pressurization to a preform, solidified carbon fibers by arranging, aligning or knitting(patent literature 1).

A problem when forming a metal-based carbon fiber composite material by the melt impregnation process is generation of metal carbide due to a chemical reaction between carbon fibers and metal in the melt, which is caused by a high temperature of the molten metal. For instance, when aluminum is used, an aluminum melt has a temperature as high as substantially 700°C, and aluminum in the melt reacts with the carbon fibers to generate Al₄C₃. It is well known that, when coming into contact with water or water vapor at room temperature, carbides such as generated Al₄C₃ are transformed into a hydrocarbon gas such as methane and a metal hydroxide, and gaps are generated between carbon fibers and the metal that is a matrix, and thereby the mechanical strength and thermal conductivity of the composite material are largely deteriorated.

As a method of inhibiting the carbide from forming in the melt impregnation method, there have been investigated methods of surface treatment such as the ceramic coating (patent literature 2) or fluorine coating (patent literature 3) to the carbon fibers. Alternatively, there have also been investigated a method of forming a preform of carbon fibers with a binder mainly made of carbon (such as pitch-based resin) (patent literature 4), or a method for inhibiting a reaction when the melt is impregnated wherein the metal used as the melt is alloyed to lower a temperature of the melt (patent literature 5).

However, as mentioned above, an increase in the cost of the composite material is likely to be caused in the method where carbon fibers are coated and the method where the preform is formed from a binder mainly made of carbon, because of need of additional steps, materials and the like. Furthermore, in a method where an alloy is used as the melt, a step of preparing the alloy becomes necessary. Still furthermore, in all methods, a high temperature is necessary and, therefore, much energy is necessary for forming a melt of metal or alloy used as a matrix.

Patent literature 1: Japanese Patent Laid-Open No. 2002-194515
Patent literature 2: Japanese Patent Laid-Open No. 2001-300717
Patent literature 3: Japanese Patent Laid-Open No. 05-125562 (1993)
Patent literature 4: Japanese Patent Laid-Open No 2000-303155
Patent literature 5: Japanese Patent Laid-Open No. 11-256254 (1999)
US-A-3 984 043 discloses a method for producing a multi-layer fiber reinforced composite by repeatedly heating a plurality of stacked filament reinforced aluminum matrix tapes (preformed) to the desired temperature.
US-A-4 110 505 discloses a method for manufacturing a metal matrix composite from an assembled stack of monolayer filament tapes (preforms).

### Disclosure of the Invention

In view of the background arts, a problem to be solved by the present invention intends to provide a metal-based carbon fiber composite material that can be prepared with commonly used cheap materials and with less energy than that of a melt method, the composite material having a wide range of dimensions and shapes (particularly large area) and being excellent in the thermal conductivity and light in weight. Such the metal-based carbon fiber composite material can be applied to personal computers, liquid crystal panels, plasma display panels and the like, which are in trouble with a heat dissipation countermeasure.

Furthermore, another problem to be solved by the present invention is to provide a producing process of a metal-based carbon fiber composite material, which uses commonly used cheap materials are used, suppresses or inhibits formation of metal carbide problematic in the melt process, can be carried out with less energy, and can give the composite material of a wide range of dimensions and shapes (large area in particular).

The first embodiment of the present invention is a producing method of a metal-based carbon fiber composite material, which comprises the steps of: adhering carbon fibers on a sheet or foil-like metal support to form a preform; stacking the preforms to form a preform laminate; and heating and pressure welding the preform laminate in a vacuum or non-oxidizing atmosphere to unite the preforms together. Here, the step of forming the preform, may be carried out by coating a mixture obtained by mixing carbon fibers and metal powder onto the metal support.Here, the carbon fibers are desirably aligned. Furthermore, the carbon fibers may be formed of a single body or a composite selected from the group consisting of pitch-based carbon fibers, PAN-based carbon fibers, carbon nano-fibers, vapor-grown carbon fibers, single wall carbon nanotubes, multi-wall carbon nanotubes and agglomerates thereof or twisted wires thereof. Alternatively, the carbon fibers may be post-treated by re-heating and the like. The metal can be selected from the group consisting of copper, aluminum, magnesium and alloys based thereon.

Another aspect of a producing method of the invention of a metal-based carbon fiber composite material comprises the steps of: preparing a coating mixture by mixing carbon fibers with an organic binder and a solvent; adhering the coating mixture on a sheet or foil-like metal support to form a preform in which a carbon fiber-containing film is formed on the metal support; stacking the preforms to form a preform laminate; and heating and pressure welding the preform laminate in a vacuum or non-oxidizing atmosphere to unite the preforms together. Here, the carbon fiber-containing film coated on the metal support may cover an entirety of the metal support or may be continuous in one direction and discontinuous in a direction perpendicular thereto. Furthermore, the coating mixture may be adhered, with the carbon fibers in the coating mixture aligning, by means of, for instance, a nozzle printing method, , and thereby maintaining a structure where carbon fibers are aligned in a produced metal-based carbon fiber composite material. Alternatively, the coating mixture can be adhered by means of a spray and dry method.

When foregoing configurations are adopted, a metal-based carbon fiber composite material which is light in weight and high in the thermal conductivity can be obtained. The metal-based carbon fiber composite is useful as a heat dissipation member for electronic devices with a semiconductor or for machines or devices having a heat generating portion. A producing method of the present invention is excellent in particular in cheaply providing planar highly thermally conductive materials and useful in providing heat dissipation substrates of notebook personal computers, liquid crystal display devices, plasma display devices, organic EL display devices and the like; accordingly, the value of the invention is very large.

### Brief Description of the Drawings

[Fig. 1A] Fig. 1A is a schematic diagram showing a metal-based carbon fiber composite material made according to the present invention and a producing method thereof, where continuous carbon fibers are aligned;
[Fig. 1B] Fig. 1B is a schematic diagram showing a metal-based carbon fiber composite material made according to the present invention and a producing method thereof, where short carbon fibers are arranged at random;
[Fig. 1C] Fig. 1C is a schematic diagram showing a metal-based carbon fiber composite material made according to the present invention and a producing method thereof, where short carbon fibers are aligned;
[Fig. 2] Fig. 2 is a diagram showing an example of a step I of a producing method of the present invention of a metal-based carbon fiber composite material;
[Fig. 3] Fig. 3 is a diagram showing an example (nozzle printing method) of a step I of a producing method of the invention of a metal-based carbon fiber composite material; [Fig. 4A] Fig. 4A is a diagram showing a nozzle tip portion having a rectifying plate, which is used in a nozzle printing method;
[Fig. 4B] Fig. 4B is a diagram showing a nozzle tip portion having an electric field application means, which is used in a nozzle printing method ;
[Fig. 4C] Fig. 4C is a diagram showing a nozzle tip portion having a magnetic field application means, which is used in a nozzle printing method;
[Fig. 5] Fig. 5 is a diagram showing an example of step I of a producing method of the present invention of a metal-based carbon fiber composite material;
[Fig. 6] Fig. 6 is a diagram showing an example of step II of a producing method of the present invention of a metal-based carbon fiber composite material;
[Fig. 7] Fig. 7 is a diagram showing an example of step III of a producing method of the present invention of a metal-based carbon fiber composite material;
[Fig. 8A] Fig. 8A is a diagram showing an example of step IV of a producing method of the present invention of a metal-based carbon fiber composite material wherein a hot-pressing method is used;
[Fig. 8B] Fig. 8B is a diagram showing an example of step IV of a producing method of the present invention of a metal-based carbon fiber composite material wherein a pulse electric sintering method is used;
[Fig. 9] Fig. 9 is a diagram showing an example of step IV of a producing method of the present invention of a metal-based carbon fiber composite material, wherein a hot pressure roll is used;
[Fig. 10] Fig. 10 is an optical micrograph of a metal-based carbon fiber composite material obtained in Example 3;
[Fig. 11] Fig. 11 is a scanning electron micrograph of a metal-based carbon fiber composite material obtained in Example 3; and
[Fig. 12] Fig. 12 is a scanning electron micrograph of a metal-based carbon fiber composite material obtained in Example 4.

### Best Mode for Carrying Out the Invention

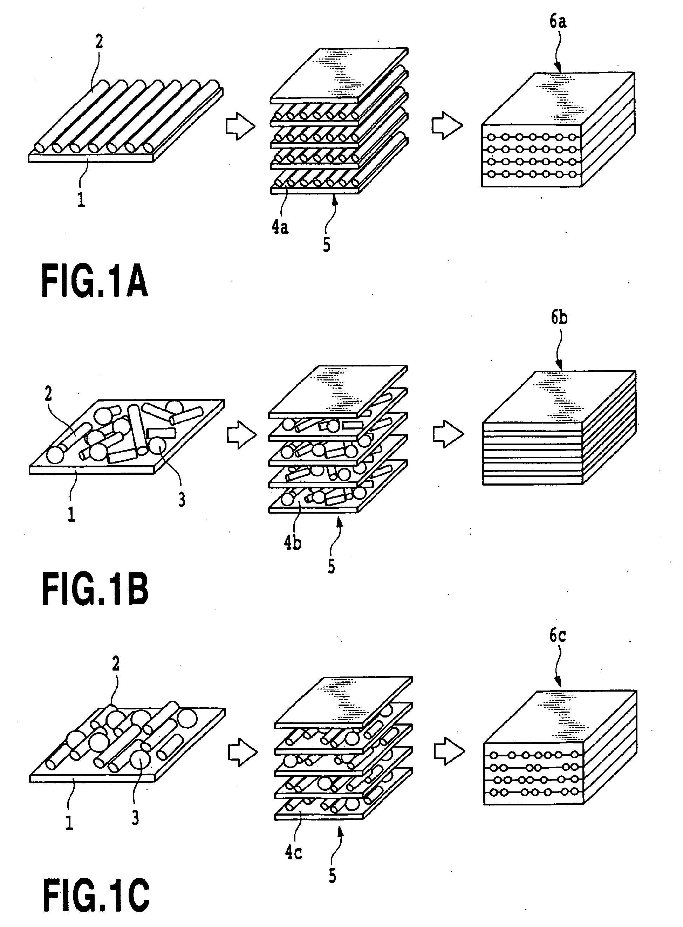

A first embodiment of the invention relates to the producing method of a metal-based carbon fiber composite material 6 that is formed of metal and carbon fibers and has a structure where a metal layer and a metal layer containing carbon fibers are alternately stacked, as shown in Figs. 1A through 1C. In Fig. 1A, there is shown a schematic diagram of a metal-based carbon fiber composite material 6a that is formed with continuous carbon fibers 2. Furthermore, in Figs. 1B and 1C, there are shown schematic diagrams of metal-based carbon fiber composite materials 6b and 6c that are formed with short carbon fibers 2 (here, the metal-based carbon fiber composite material 6b is a material wherein carbon fibers 2 are arranged at random, and the metal-based carbon fiber composite material 6c is a material wherein carbon fibers 2 are aligned in one direction). The metal used in the metal-based carbon fiber composite material 6 of the present invention can be selected from a group made of copper, aluminum, magnesium and alloys based thereon, from viewpoints of the thermal conductivity and workability. The metal layer can be formed of a self-supporting sheet (thickness: 50 to 500 µm) or a self-supporting foil (thickness: 100nm to 50 µm). In the description below, there are cases that the metal sheet and metal foil are generically called a metal support.

The carbon fibers 2 used in the metal-based carbon fiber composite material 6 of the present invention may be selected from the group consisting of pitch-based carbon fibers, PAN-based carbon fibers, carbon fibers obtained by reheating the pitch-based or PAN-based carbon fibers (the carbon fibers that can be handled as continuous fiber having a diameter in the range of 1 to 10 µm and a length of 50 mm or more, or chopped fibers having a diameter in the aforementioned range and a length in the range of 1 to 50 mm), vapor grown carbon fibers (diameter: 10 nm to 40 µm, length: 1 µm to 50 mm), carbon nano-fibers (diameter: 10 nm to 40 nm, length: 1 µm to 50 mm), single wall carbon nanotubes (diameter: 1.4 nm to 10 nm, length: 1 µm to 50 mm), multi-wall carbon nanotubes (diameter: 2 nm to 40 µm, length: 1 µm to 50 mm), or agglomerates thereof, or wires obtained by twisting or spinning the carbon nano-fibers or carbon nanotubes. Alternatively, in the metal-based carbon fiber composite material 6 of the invention, one kind of the carbon fiber may be used solely (as a single body) or a composite in which a plural kinds of carbon fibers are mixed may be used as the carbon fibers 2.

Furthermore, when the carbon fibers are heat treated (reheated) in an inert atmosphere at a temperature in the range of 2000 to 3000°C, the stiffness and thermal conductivity thereof can be improved. Accordingly, the carbon fibers heat-treated for complying with the characteristics necessary for the composite material can be used as well.

The carbon fiber-containing metal layer in the present invention can be formed in such a manner that the carbon fibers 2 and the metal support 1 are brought into contact with each other, followed by heating and pressure welding to plastically deform a portion of the metal support 1 so as to surround a circumference of the carbon fibers 2. Alternatively, a carbon fiber-containing metal layer may be formed by disposing a mixture of the carbon fibers 2 and particles of metal powder 3 as a bonding auxiliary agent onto the metal support 1, followed by applying heat and pressure to fuse particles of the metal powder 3 and plastically deform a portion of the metal support 1. In all cases, a remaining portion of the metal support 1 forms a metal layer.

In the case where the metal layer and the carbon fiber-containing metal layer are alternately stacked, when the carbon fibers 2 contained in the carbon fiber-containing metal layer are aligned in one direction, the thermal conductivity in a carbon fiber-aligned direction of the metal-based carbon fiber composite material 6 can be further improved. The carbon fibers 2 can be aligned according to various methods described below.

The metal-based carbon fiber composite material 6 can be obtained as a sheet material having a thickness in a lamination direction in the range of 0.1 to 10 mm and preferably in the range of 0.1 to 3 mm. In the case where such a thin sheet material is formed, deterioration of the thermal properties (such as the thermal conductivity and thermal expansion coefficient) can be prevented when bending deformation is applied after production, since a micro-structural breakdown such as rupture does not occur. The metal-based carbon fiber composite material 6 having a thickness in the foregoing range can maintain its thermal properties, even when the bending deformation of a curvature radius of 30 mm or less, more particularly, in the range of 1 to 30 mm, is applied to the composite material. This is because both the carbon fibers and metal in the composite material do not suffer from the micro-structural breakdown such as rupture.

The present invention provides a specific method that enables to industrially produce a layer-like structure having a configuration where a metal layer and a metal-based carbon fiber layer in which carbon fibers are dispersed in the metal are alternately stacked.

A producing method of the embodiment comprises: step I of adhering carbon fibers 2 on a metal support 1 to form a preform 4; step II of stacking the preforms 4 to form a preform laminate 5; and step IV of heating and pressurizing the preform laminate 5 in a vacuum or non-oxidizing atmosphere to pressure weld the preforms 4 each other to integrate them together to obtain a metal-based carbon fiber composite material 6. Here, if organic binder or an organic solvent is used for the purpose of fixing the carbon fibers 2 on a surface of the metal support 1 in the step I for forming the preform 4, step III "de-bindering" may be further carried out between the step II and step IV. In step III, the laminate is heated to a temperature of an extent that the surface of the carbon fibers is not oxidized, to remove the organic binder or organic solvent.

The producing method of the invention of the metal-based carbon fiber composite material has variations in the respective steps, depending on sizes and alignment methods of the carbon fibers 2, the use or nonuse of the metal powder 3 as a bonding auxiliary and the like. Several different producing methods can be configured, by combining the steps.

Step I is a step of combining a metal support 1 that forms a metal layer with carbon fibers 2 to form a preform 4. In this step, the carbon fibers 2 are not necessarily aligned but preferably aligned in one direction. Depending on whether the carbon fibers 2 can be handled as continuous fibers or short fibers, different methods can be applied.

When the carbon fibers 2 can be handled as continuous fibers, that is, when the carbon fibers 2 are fibers having a length of 50 mm or more such as pitch-based or PAN-based carbon fibers or twisted wires of the carbon fibers, the carbon fibers 2 can be readily aligned to obtain a preform 4a, by use of a method of disposing the carbon fibers 2 onto the metal support 1 with applying the tension from both ends, as shown in Fig. 1A. In addition, the carbon fibers 2 can be fixed on the metal support 1, by either coating the carbon fibers 2 with a binder before aligning, or coating them with a binder on the metal support 1 after aligning by conventional methods such as spraying. Alternatively, metal powder 3 as the bonding auxiliary can be applied and fixed to the carbon fibers 2 simultaneously or separately with the binder, in order to improve the adhesion between metal supports 1 or between metal support 1 and carbon fibers 2 after heating and pressure welding.

Preferably, the binder useful in step I can be readily volatilized or burned out at a temperature to an extent that the carbon fibers 2 is not oxidized, in step III described below. Preferably, the binder can be volatilized or burned out at a temperature of 400°C or less. Specifically, an organic resin such as Pluronic dispersion adhesive, PEG or the like can be used. Optionally, a low-boiling point organic solvent may be used by mixing with the binder, in order to improve coatabiliity and viscosity of the binder. Useful organic solvents are ones that can be volatilized or burned out at a temperature that the carbon fibers is not oxidized. Exemplary organic solvents include ethyl acetate, acetone, toluene, 1,2-dimethoxyethane and diethylene glycol dimethyl ether.

The metal powder 3 that may be added in step I as a bonding auxiliary is preferably formed of a similar material to the metal support 1 for uniting with the material that forms the metal support 1 after the heating and pressure welding. In general, a particle diameter of the metal powder 3 is desirably in the range of 10 nm two 50 µm, although it depends on the employed carbon fibers 2.

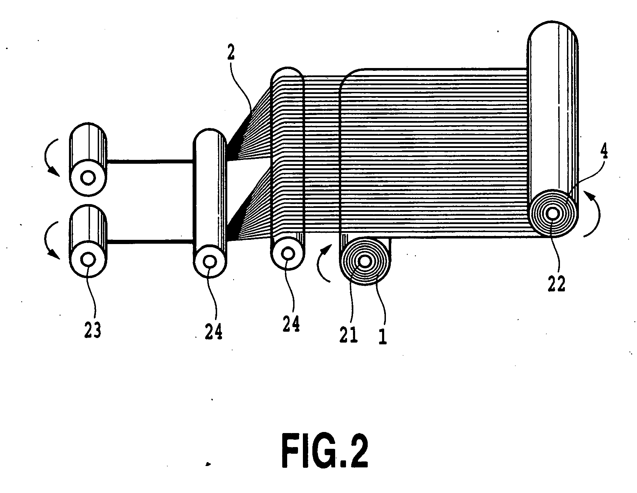

An illustrative mode particularly suitable for the mass production is shown in Fig. 2, where the carbon fibers 2 can be handled as the long continuous fibers. While the metal support 1 is transferred from a unwinding roll 21 to a winding roll 22, continuous carbon fibers 2 unwound from a bobbin 23 are, fixed on the metal support 1 with aligning. In this case, the carbon fibers 2 of 1000 or more can be simultaneously fixed on the metal support 1 by increasing the number of the bobbins 23. In the method of Fig. 2, to the carbon fibers 2 are applied tension and a suppression force to the metal support 1, by passing a winding roll 22, a bobbin 23 and optionally one or a plurality of tension rolls 24 (two rolls shown in Fig. 2) . In the embodiment of Fig. 2, a binder may be coated on the carbon fibers 2 after passing through the tension roll 24 or may be coated on the metal support 1 after the carbon fibers 2 are aligned.

On the other hand, in the case that the carbon fibers 2 can be handled as the short fibers, that is, in the case that the carbon fibers 2 can be handled as powders, the carbon fibers 2 or a powdery mixture of the carbon fibers 2 and metal powder 3 can be sprinkled on the metal support 1 to form a preform 4b where as shown in Fig. 1B carbon fibers are arranged at random. The carbon fibers 2 which can be handled as the short fibers are 50 mm or less in the length, such as chopped fibers, vapor grown carbon fibers, carbon nano-fibers, single wall carbon nanotubes, multi-wall carbon nanotubes or mixtures thereof. After the powdery mixture is sprinkled, a binder or a solution of a binder in an organic solvent may be separately coated according to conventional methods such as a spraying method, to fix the powdery mixture on the metal support 1 . Furthermore, a method of naturally adhering without a binder to fix may be applied.

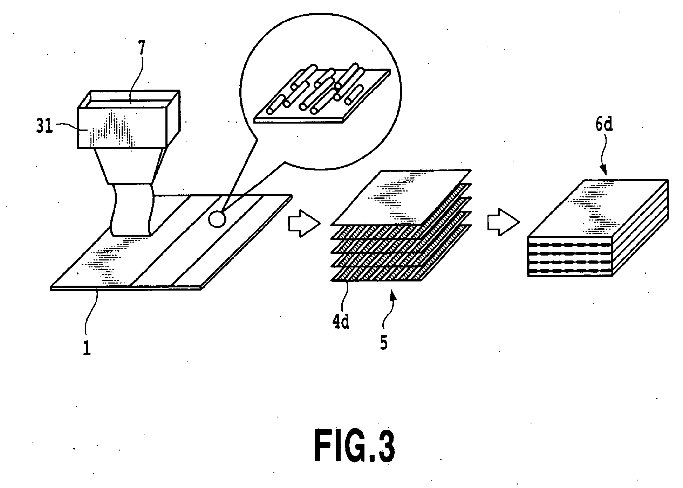

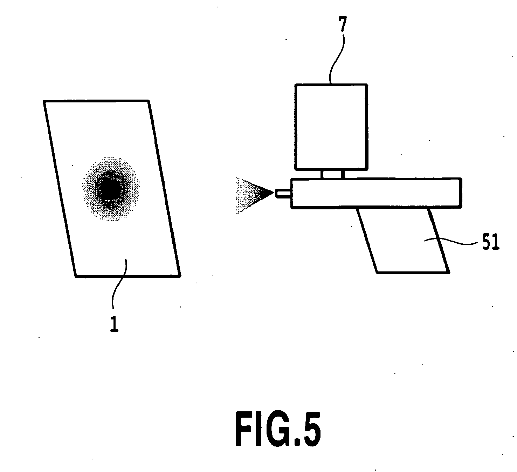

Alternatively, a coating mixture 7 is prepared by mixing the carbon fibers 2, metal powder 3 and organic solvent and the coating mixture 7 may be coated and fixed on the metal support 1. The coating mixture 7 may optionally contain a binder. The coating mixture 7 used in this step is formed by mixing the carbon fibers 2, metal powder 3 and the binder (if present) together in a solvent with a conventional mixer such as a ball mill. If the coating mixture does not contain the binder, after the coating mixture is carried on the metal support 1, a binder or a solution of a binder in an organic solvent may be separately coated by conventional methods such as a spraying method. In this case, a method of naturally adhering without a binder to fix may be applied, as well. Coating of the coating mixture 7 can be carried out by: a nozzle printing method shown in Fig. 3, in which the coating mixture 7 is discharged from a nozzle 31 to dispose the carbon fibers 2 on the metal support 1; a spray and dry method where the coating mixture 7 is sprayed on the metal support 1 and dried to dispose the carbon fibers 2 as shown in Fig. 5; or a screen printing method. When adopting the method in which the coating mixture is used, it is possible to form not only a preform 4b where carbon fibers 2 are arranged at random as shown in Fig. 1B but also a preform 4c where carbon fibers 2 are aligned in one direction as shown in Fig. 1C.

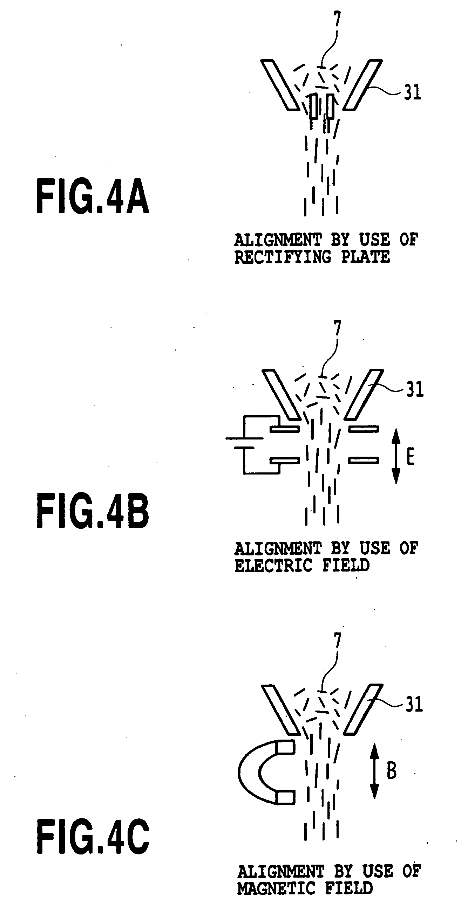

When forming the preform 4c where the carbon fibers 2 are aligned as shown in Fig. 1C, the nozzle printing method can be advantageously applied. The carbon fibers discharged from the nozzle 31 can be aligned in parallel with a discharge direction, for example, by using: a method where rectifying plates parallel with a discharge direction are disposed in the neighborhood of an outlet of the nozzle 31 (Fig. 4A) of the nozzle 31; a method where by use of an electric field parallel with the discharge direction is applied by electric field applying means in the neighborhood of the outlet of the nozzle 31 (Fig. 4B) ; or a method where a magnetic field parallel with the discharge direction is applied by magnetic field applying means in the neighborhood of the outlet of the nozzle 31 (Fig. 4C) . By employing these methods, the carbon fibers can be aligned in parallel with a runway direction of the nozzle 31. In the case that these methods are used, it is desirable that the aspect ratio of the carbon fibers 2 (carbon fiber length/carbon fiber diameter) is 10 or more and preferably 100 or more. Furthermore, when the coating mixture 7 containing the carbon fibers 2 is coated on the metal support 1, the coating mixture 7 may be applied evenly on an entire surface of the metal support 1 or alternatively, as shown in Fig. 3, a preform 4d having a stripe structure where the coating mixture 7 is formed continuously in one direction (in a runway direction of a nozzle in Fig. 3) and discontinuously in a direction perpendicular thereto may be formed.

On the other hand, when forming a preform 4b where the carbon fibers 2 are not aligned as shown in Fig. 1B, the above-described spray and dry method can be preferably used. It is desirable to use a spraying device 51 as shown in Fig. 5 to adhere the coating mixture 7 uniformly onto the metal support 1.

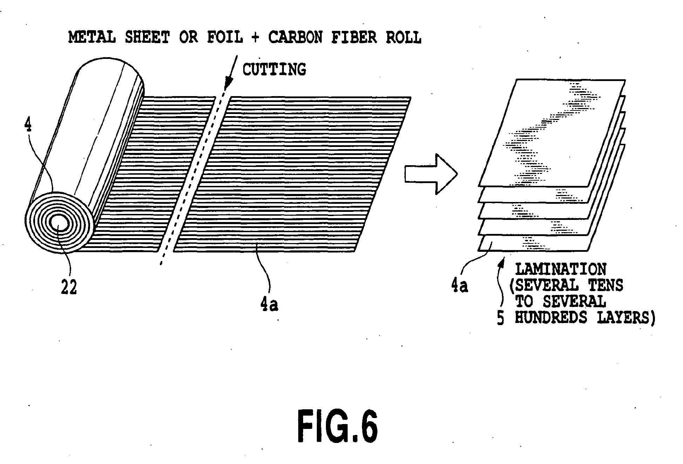

Step II is a step where a predetermined number of preforms 4 prepared in step I (any one of 4a through 4d may be used), on which the carbon fibers are fixed, is stacked to form a preform laminate 5, as shown in Figs. 1A through 1C and Fig. 3. A dimension of a resultant metal-based carbon fiber composite material obtained by the heating and pressure welding of step IV can be estimated from the true densities of the metal support 1, carbon fibers 2 and metal powder 3 as a bonding auxiliary (if used) which are employed. Accordingly, the number of the preforms 4 laminated in this step can be readily determined. Alternatively, when using a preform 4 wound on a winding roll 22 which is formed according to a method shown in Fig. 2, the preform may be unwound, cut into preforms 4a having a desired shape, and then a predetermined number of the preforms 4a is stacked to form a preform laminate 5, as shown in Fig. 6.

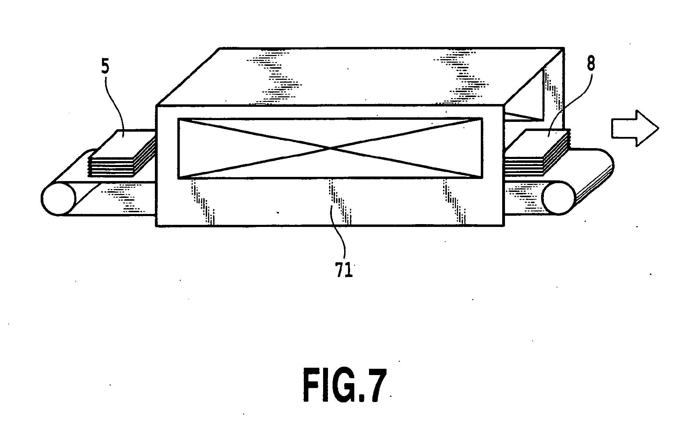

"De-bindering" of step III is an optional step that is preferably carried out if a binder is used when the preform 4 is formed. The preform laminate 5 is heated, without applying a pressing force, in an inert or oxidizing atmosphere, to a temperature to an extent that a surface of the carbon fiber 2 is not oxidized. Thereby, a binder and an organic solvent present in the coating mixture 7 are burned out or volatilized to form a preform laminate 8 that does not contain the binder. When using aluminum, magnesium and alloys based thereon as the metal support, this step is preferably carried out in an inert atmosphere. Here, a heating temperature is preferably in the range of 200 to 400°C. The useful inert atmosphere comprises nitrogen or an inert gas such as argon, or a reduced pressure condition may be used. The useful oxidizing atmosphere comprises air, oxygen-enriched air, pure oxygen or the like. This step can be readily industrialized by means of a "de-bindering" furnace 71 such as shown in Fig. 7, which is used in a production of laminated ceramic capacitors, for example. In Fig. 7, a conveyer type furnace is shown. However, any means known in the art such as a box type furnace may be used.

In the heating and pressurizing step of step IV, the pressing force and heat are applied, in a vacuum or non-oxidizing atmosphere, to the preform laminate 5 obtained in step II (when the binder is not used) or a preform laminate 8 not containing the binder that is obtained in step III, to cause the plastic deformation and mutual diffusion of the metal support 1 and the metal powder 3. Thereby, the circumference of the carbon fibers 2 is surrounded with the metal to form a carbon fiber-containing metal layer. As a result, this step gives a metal-based carbon fiber composite material 6 in which the carbon fiber-containing metal layer and the metal layer are alternately laminated.

In this step, when using aluminum or an aluminum-based alloy as the metal support, the preform laminate is heated at a temperature in the range of 500 to 650°C. When using magnesium or a magnesium-based alloy as the metal support, the preform laminate is heated at a temperature in the range of 500 to 630°C. When using copper or a copper-based alloy as the metal support, the preform laminate is heated to a temperature in the range of 800 to 1050°C. These temperatures are lower than temperatures of molten metals in the conventional molten metal method; accordingly, energy consumption can be reduced in the inventive method. Furthermore, a pressing force is applied simultaneously to the preform laminate. The specific pressing force depends on materials that constitute the metal support and the metal powder, the desired reduction rate and the like. However, a pressing force is applied generally in the range of 20 to 100 MPa and preferably in the range of 50 to 100 MPa. Furthermore, in this step, it is preferable to apply heat and pressing force in a vacuum (30 Pa or less in pressure) or a non-oxidizing atmosphere such as nitrogen, an inert gas such as argon or the like, for preventing oxidation of the metal support and metal powder.

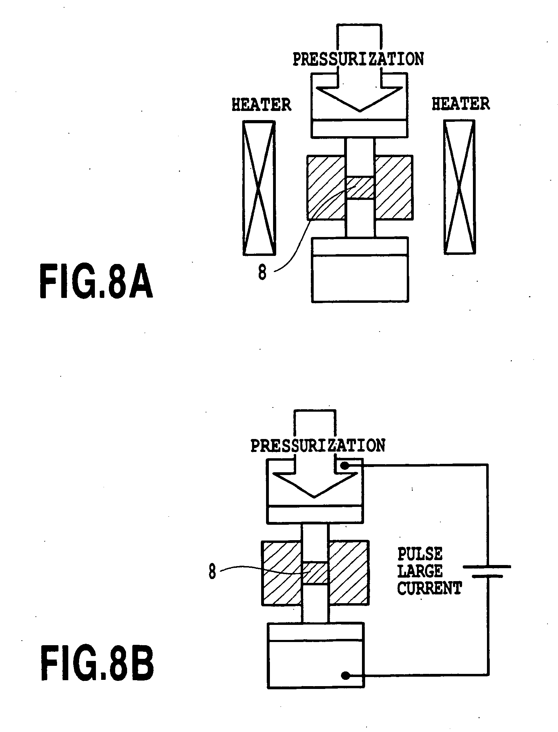

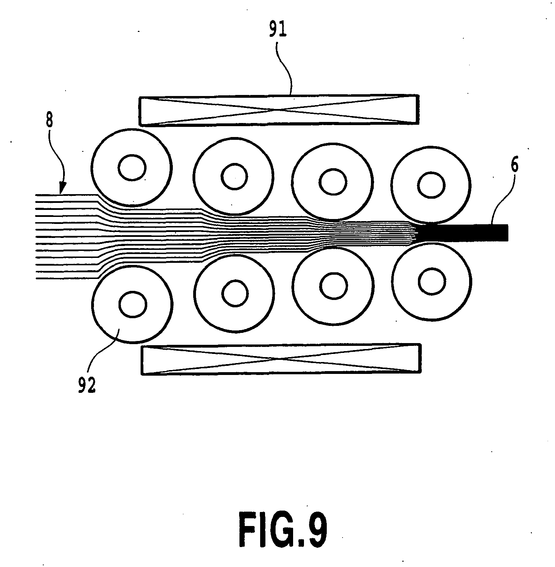

In this step, there can be used various kinds of heating furnaces which can simultaneously apply the pressing force and heat to the preform laminate 5 or the preform laminate 8 that does not contain the binder. For instance, in a small-scale production, a hot-press furnace shown in Fig. 8A or a pulse electric sintering furnace shown in Fig. 8B can be used. For instance, the pulse electric sintering furnace shown in Fig. 8B has a dice having a rectangular throughhole of a 20 to 40 mm square and upper and lower punches for compressing a material inside of the dice from an up and down direction. When a large pulse current is applied between the punches, a material to be compressed can be pressurized and heated. In a large-scale production, there can be used a hot pressure roll (including a heater 91 and a plurality of sets of pressure rolls 92) such as shown in Fig. 9, which is used in a producing step of a metal sheet, and thereby, large-area planar metal-based carbon fiber composite materials 6 can be obtained at high productivity.

### Examples

### (Example 1)

The example provides a metal-based carbon fiber composite material in which carbon fibers that can be handled as continuous fibers are aligned in one direction. Pitch-based carbon fibers was used as the carbon fiber, which have a diameter of 10 µm, are continuous in a length direction and have the thermal conductivity of 1000 W/mK. An aluminum foil having a thickness of 10 µm was used as a metal support. A device shown in Fig. 2 was used for fixing the carbon fibers onto the aluminum foil. The carbon fibers wound around a bobbin were drawn, and low-molecular weight polyethylene glycol as an adhesive was coated along with applying tension. The following steps was conducted in a consecutive manner: adhering carbon fibers which was aligned due to the tension onto an unwound aluminum foil; curing an adhesive; and winding up the foil. The aluminum foil to which the carbon fibers were adhered (i.e. preform) was unwound from a roll and cut into a dimension of 200 x 300 mm. Five hundreds cut sheets were laminated, followed by laminating on the uppermost surface an aluminum foil to which the carbon fibers are not adhered as a cover, thereby a preform laminate 5 was obtained. The preform laminate 5 was heated at 350°C in air to remove the low-molecular weight polyethylene glycol used as the adhesive. Then, the preform laminate 5 was heated and pressure welded by means of a hot pressure roll as shown in Fig. 9 (provided with 5 sets of pressure rolls), under a vacuum (10 Pa), at 500°C, under pressure of 20 MPa at the respective pressure rolls and at the reduction rate in the range of 10 to 30%, and thereby a metal-based carbon fiber composite material 6 was obtained.

The metal-based carbon fiber composite material 6 had a thickness of 1 mm in a lamination direction, a content of substantially 40% of the carbon fibers based on a total weight and a thermal conductivity of 500 W/mK in a fiber alignment direction, the thermal conductivity being twice or more the thermal conductivity of simple aluminum (the thermal conductivity: approximately 200W/mK). Furthermore, the thermal expansion coefficient of the composite material was 5 ppm/°C in the fiber alignment direction and 10 ppm/°C in a direction perpendicular to the fibers. That is, these coefficients could be reduced to substantially one fourth (fiber alignment direction) and one half (direction perpendicular to the fibers) of 23 ppm/°C of elemental aluminum, respectively. Furthermore, both the carbon fibers and the metal did not exhibit the micro-structural breakdown such as the rupture, and the thermal conductivity or the thermal expansion coefficient are considered hardly affected, when the bending deformation at the curvature radius of 5 mm and bending angle of 60° was applied to obtained metal-based carbon fiber composite material 6.

### (Example 2)

In the example, a metal-based carbon fiber composite material in which carbon fibers that can be handled as short fibers were aligned in one direction is provided. Vapor grown carbon fibers having a diameter of 200 nm, a length in the range of 5 to 20 µm and the thermal conductivity of 2000 W/mK were mixed with 30% of copper powder having a particle size of substantially 100 nm by means of a ball mill. To an obtained mixture, acetone and a dispersion adhesive (Pluronic (registered trade name) F68) were added and mixed to obtain an ink-like coating mixture. The obtained coating mixture was coated over an entire surface of a copper foil having a thickness of 6 µm by means of a nozzle printing method as shown in Fig. 3, so that a film thickness may be 6 µm to form a preform. The preform wound on a roll after curing the dispersion adhesive (Pluronic (registered trade name) F68). The preform was unwound from a roll and cut into a dimension of 200 x 300 mm. Five hundreds cut preforms were laminated, followed by laminating on the uppermost surface a copper foil that is not printed as a cover, thereby a preform laminate was obtained. The preform laminate was heated at 350°C in air to volatilize or burn out the Pluronic (registered trade name) F68. Subsequently, a preform laminate was heated and pressure welded by heating the preform laminate at 700°C in an inert atmosphere, under pressure of 20 MPa at the respective pressure rolls, and by use of a five-stage hot rolls of the reduction rate in the range of 10 to 30%, and thereby a metal-based carbon fiber composite material was obtained.

The obtained metal-based carbon fiber composite material had a thickness of 1 mm in a lamination direction and a content of substantially 30 weight percent of the carbon fibers based on a total weight. Furthermore, the metal-based carbon fiber composite material of the example had the thermal conductivity of 600 W/mK in a direction where the carbon fibers are aligned, which is 1.5 times the thermal conductivity of simple copper (the thermal conductivity: approximately 400 W/mK). Still furthermore, the thermal expansion coefficient of the composite material was 7 ppm/°C in the fiber alignment direction and 8 ppm/°C in a direction perpendicular to the fibers. That is, these coefficients could be reduced to substantially one half or less that of copper element, which is 17 ppm/°C. Furthermore, both the carbon fibers and the metal did not exhibit the micro-structural breakdown such as the rupture, and the thermal conductivity or the thermal expansion coefficient are considered hardly affected, when the bending deformation was applied at the curvature radius of 5 mm and bending angle of 60° to the metal-based carbon fiber composite material 6.

### (Example 3)

The present example provides a metal-based carbon fiber composite material in which carbon fibers that can be handled as continuous fibers are aligned in one direction, the composite material being formed by means of a pulse electric sintering method that is used in a small-scale production. Pitch-based carbon fibers was used as the carbon fiber, which have a diameter of 10 µm, are continuous in a length direction and have the thermal conductivity of 1000 W/mK. Aluminum powder having an average particle size of 30 µm was used as the bonding auxiliary. An aluminum sheet having a thickness of 100 µm was used as a metal support. Firstly, the aluminum powder was suspended in an ethanol solvent. Substantially 6000 carbon fibers were bundled and held, dipped in the suspension, and volatilizing and removing only ethanol, so that there were obtained the carbon fibers to a surface of which the aluminum powder is adhered even after the solvent is dried owing to an electrostatic force. As the pulse electric sintering furnace such as shown in Fig. 8B, a furnace having a dice having a rectangular throughhole of 20 mm square was used. Up to a length of substantially 40 mm, the pitch-based carbon fibers can maintain the directionality, without applying the tension, owing to its own elasticity. The carbon fibers to which the aluminum powder is adhered was cut to a length of 20 mm, disposing aligned in one direction in a dice in which a lower punch was set after the cutting, and then placing an aluminum sheet thereon. The carbon fiber and the aluminum sheet were alternately stacked respectively up to 30 layers in the dice. After the stacking, the laminate in the dice was sandwiched up and down with punches. The pulse electric sintering furnace as a whole was evacuated to a vacuum of pressure of 10 Pa, a pressing force of 25 MPa was applied to upper and lower punches under heating at 600°C, and thereby a metal-based carbon fiber composite material having a thickness of 5 mm in a lamination direction was obtained.

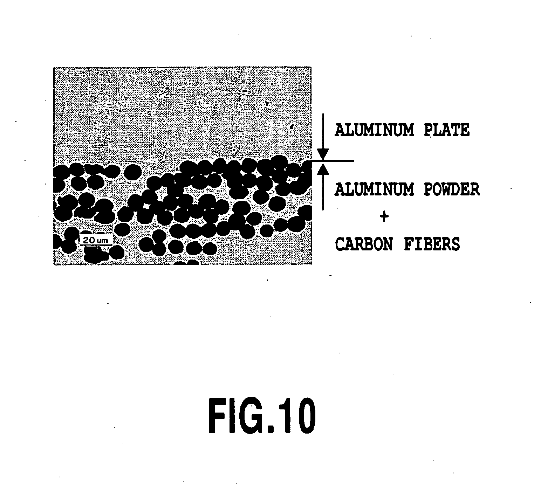

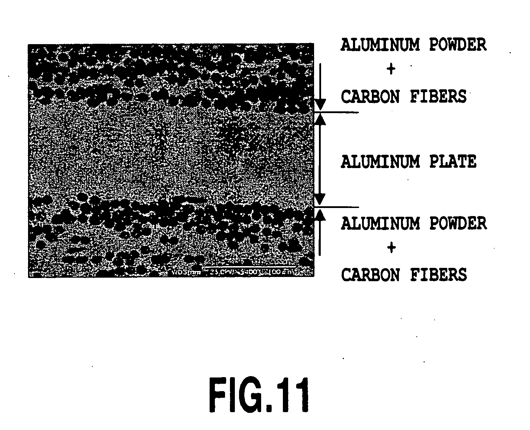

An optical micrograph of a section of the obtained metal-based carbon fiber composite material is shown in Fig. 10 and a scanning electron micrograph thereof is shown in Fig. 11. As realized from Figs. 10 and 11, the metal-based carbon fiber composite material of the invention is found to have a structure where a metal layer (derived mainly from the aluminum sheet) and a carbon fiber-containing metal layer (derived mainly from pitch-bases carbon fibers and aluminum powder) are alternately stacked. Furthermore, bonding states between the aluminum sheet and the carbon fibers and between the aluminum sheet and the aluminum powder were found to be excellent.

### (Example 4)

The present example provides a metal-based carbon fiber composite material in which carbon fibers that can be handled as short fibers are arranged at random, the composite material being formed by means of a pulse electric sintering method that is used in a small-scale production. Vapor grown carbon fibers that have a diameter of 200 nm, a length of 5 to 20 µm and the thermal conductivity of 2000 W/mK were used as the carbon fibers. Aluminum powder having an average particle size of 30 µm was used as the bonding auxiliary. An aluminum sheet having a thickness of 100 µm was used as a metal support. By means of a ball mill, 20 parts of the vapor grown carbon fibers and 80 parts of aluminum powder were mixed in an ethanol solvent, followed by drying at room temperature, to give a mixture of carbon fibers and aluminum.

By use of a pulse electric sintering furnace having a dice having a rectangular throughhole of 20 mm square, into the dice where a lower punch was set, the aluminum sheet and the mixture of the carbon fibers and aluminum were alternately stacked up to 30 layers respectively, followed by finally stacking an aluminum sheet. Then, an upper punch was set in the dice. The pulse electric sintering furnace as a whole was evacuated to a vacuum of pressure of 10 Pa, a pressing force of 25 MPa was applied to the upper and lower punches under heating at 600°C, and thereby a metal-based carbon fiber composite material having a thickness of 5 mm in a lamination direction was obtained.

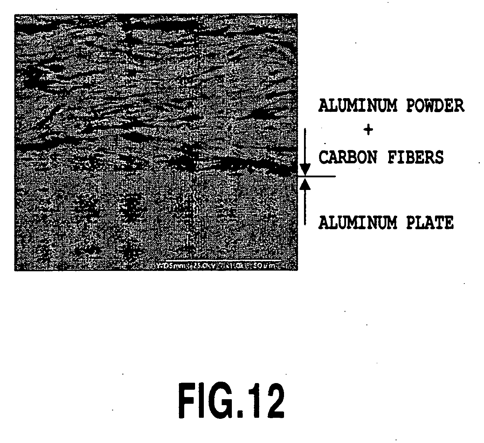

A scanning electron micrograph of a section of an obtained metal-based carbon fiber composite material is shown in Fig. 12. As obvious from Fig. 12, the metal-based carbon fiber composite material of the invention is found to have a structure where a metal layer (derived mainly from the aluminum sheet) and a carbon fiber-containing metal layer (derived mainly from vapor-grown carbon fibers and aluminum powder) are alternately stacked. Furthermore, bonding states between the aluminum sheet and the carbon fibers and between the aluminum sheet and the aluminum powder were found to be excellent.

In the above examples, only aluminum and copper were used as materials of the metal supports. However, from the characteristics demanded for the metal-based carbon fiber composite material of the invention and industrial productivity, other than the metals, magnesium or alloys based thereon can be used as well.

## Claims

1. A producing method of a metal-based carbon fiber composite material comprising the steps of:
adhering carbon fibers on a sheet or foil metal support to form a preform;
stacking the preforms to form a preform laminate; and
heating and pressure welding the preform laminate in a vacuum or non-oxidizing atmosphere to unite the preforms together,
wherein, in the step of forming the preform, a mixture obtained by mixing carbon fibers and a metal powder is coated on the metal support.

2. A producing method of a metal-based carbon fiber composite material **characterized by** comprising the steps of:
mixing carbon fibers with an organic binder and a solvent to prepare a coating mixture;
adhering the coating mixture on a sheet or foil metal support to form a preform in which on the metal support a carbon fiber-containing film is formed;
stacking the preforms to form a preform laminate; and
heating and pressure welding the preform laminate in a vacuum or non-oxidizing atmosphere to unite the preforms together.

3. The producing method of claim 2 of a metal-based carbon fiber composite material, wherein the carbon fiber-containing film coated on the metal support covers an entirety of the metal support.

4. The producing method of claim 2 of a metal-based carbon fiber composite material, wherein the carbon fiber-containing film coated on the metal support is continuous in one direction and discontinuous in a direction perpendicular thereto.

5. The producing method of claim 2 of a metal-based carbon fiber composite material, wherein the coating mixture is adhered with carbon fibers in the coating mixture aligning and a structure where the carbon fibers are aligned is maintained in the produced metal-based carbon fiber composite material.

6. The producing method of claim 5 of a metal-based carbon fiber composite material, wherein the coating mixture is adhered by means of a nozzle printing method.

7. The producing method of claim 2 of a metal-based carbon fiber composite material, wherein the coating mixture is adhered by use of a spray and dry method.

## Patentansprüche

1. Herstellungsverfahren für ein Kohlenstofffaser-Verbundmaterials auf Metallbasis, umfassend die folgenden Schritte: Kleben von Kohlenstofffasern auf einen blattförmigen oder folienartigen Metallträger zur Bildung einer Vorform;
Aufeinanderschichten der Vorformen zur Bildung eines Vorform-Laminats; und
Erhitzen und Druckschweißen des Vorform-Laminats in einem Vakuum oder in nicht oxidierender Atmosphäre zur Vereinigung der Vorformen miteinander,
wobei beim Schritt der Bildung der Vorform ein Gemisch, das durch Mischen von Kohlenstofffasern und einem Metallpulver erhalten wurde, schichtförmig auf den Metallträger aufgetragen wird.

2. Verfahren zur Herstellung eines Kohlenstofffaser-Verbundmaterials auf Metallbasis, **gekennzeichnet durch** die folgenden Schritte:
Mischung von Kohlenstofffasern mit einem organischen Bindemittel und einem Lösungsmittel zur Herstellung einer Beschichtungsmischung;
Kleben der Beschichtungsmischung auf einen blattförmigen oder folienartigen Metallträger zur Bildung einer Vorform, bei dem auf dem Metallträger ein kohlenstofffaserhaltiger Film gebildet wird;
Aufeinanderschichten der Vorformen zur Bildung eines Vorformlaminats; und
Erhitzen und Druckschweißen des Vorformlaminats in einem Vakuum oder einer nicht oxidierenden Atmosphäre zur Vereinigung der Vorformen miteinander.

3. Verfahren zur Herstellung eines Kohlenstofffaser-Verbundmaterials auf Metallbasis nach Anspruch 2, wobei der kohlenstofffaserhaltige Film, der auf dem Metallträger schichtförmig aufgetragen ist, den gesamten Metallträger bedeckt.

4. Verfahren zur Herstellung eines Kohlenstofffaser-Verbundmaterials auf Metallbasis nach Anspruch 2, wobei der kohlenstofffasernhaltige Film, der auf dem Metallträger schichtförmig aufgetragen ist, in einer Richtung kontinuierlich und in einer senkrechten Richtung dazu diskontinuierlich ist.

5. Verfahren zur Herstellung eines Kohlenstofffaser-Verbundmaterials auf Metallbasis nach Anspruch 2, wobei das Beschichtungsgemisch geklebt wird mit ausgerichteten Kohlenstofffasern in dem Beschichtungsgemisch und einer Struktur mit ausgerichteten Kohlenstofffasern, die in dem fertigen Kohlenstofffaser-Verbundmaterial auf Metallbasis erhalten bleibt.

6. Verfahren zur Herstellung eines Kohlenstofffaser-Verbundmaterials auf Metallbasis nach Anspruch 5, wobei das Beschichtungsgemisch mit Hilfe eines Düsendruckverfahrens geklebt wird.

7. Verfahren zur Herstellung eines Kohlenstofffaser-Verbundmaterials nach Anspruch 2, wobei das Beschichtungsgemisch mittels eines Sprüh- und Trocknungsverfahrens geklebt wird.

## Revendications

1. Un procédé de fabrication d'un matériau composite en fibres de carbone à base de métal, comprenant les étapes consistant à :
mettre en adhésion des fibres de carbone sur un support en tôle mince ou en feuille métallique, pour former une préforme ;
empiler les préformes pour former un laminé de préformes ; et
souder par chauffage et pressage le laminé de préformes sous un vide, ou une atmosphère non oxydante, pour réunir ensemble les préformes,
dans lequel, à l'étape de formage de la préforme, un mélange, obtenu par mélange de fibres de carbone et d'une poudre métallique, est appliqué en revêtement sur le support métallique.

2. Un procédé de fabrication d'un matériau composite en fibres de carbone à base de métal, **caractérisé par** le fait de comprendre les étapes consistant à :
mélanger des fibres de carbone à un liant organique et à un solvant, pour préparer un mélange de revêtement ;
mettre en adhésion le mélange de revêtement sur un support en tôle mince ou en feuille métallique, pour former une préforme dans laquelle un film contenant des fibres de carbone est formé sur le support métallique ;
empiler les préformes pour former un laminé de préformes ; et
souder par chauffage et pressage le laminé de préformes sous un vide, ou une atmosphère non oxydante, pour réunir ensemble les préformes.

3. Le procédé de fabrication, selon la revendication 2, d'un matériau composite en fibres de carbone à base de métal, dans lequel le film contenant des fibres de carbone, appliqué en revêtement sur le support métallique, couvre une totalité du support métallique.

4. Le procédé de fabrication, selon la revendication 2, d'un matériau composite en fibres de carbone à base de métal, dans lequel le film contenant des fibres de carbone, appliqué en revêtement sur le support métallique, est continu dans une direction et discontinu dans une direction perpendiculaire à celle-ci.

5. Le procédé de fabrication, selon la revendication 2, d'un matériau composite en fibres de carbone à base de métal, dans lequel le mélange de revêtement est mis en adhésion avec des fibres de carbone, dans l'alignement de mélange de revêtement, et une structure, dans laquelle les fibres de carbone sont alignées, est maintenue dans le matériau composite en fibres de carbone à base de métal produit.

6. Le procédé de fabrication, selon la revendication 5, d'un matériau composite en fibres de carbone à base de métal, dans lequel le mélange de revêtement est mis en adhésion à l'aide d'un procédé d'impression par buse.

7. Le procédé de fabrication, selon la revendication 2, d'un matériau composite en fibres de carbone à base de métal, dans lequel le mélange de revêtement est mis en adhérence par utilisation d'un procédé de pulvérisation et séchage.
